# DEMANDE DE BREVET EUROPEEN

(11) **EP 2 159 851 A1**
(43) Date de publication de la demande: **03.03.2010**
(21) Numéro de dépôt: 08163425.5
(22) Date de dépôt: 01.09.2008
(51) Int. Cl.: H01L 31/072, H01L 31/18, H01L 31/20

(54) **Procédé pour limiter la croissance épitaxiale dans un dispositif photoélectrique à hétérojonctions et un tel dispositif photoélctrique**

(71) Demandeur: Université de Neuchâtel, 2000 Neuchatel (CH)
(72) Inventeur: Olibet, Sara, Somerville, MA 02144 (US); Monachon, Christian, 1071 Rivaz (CH); Damon-Lacoste, Jérôme, 2000 Neuchâtel (CH); Ballif, Christophe, 2000 Neuchâtel (CH)
(74) Mandataire: GLN

(57) **Abrégé**

L'invention concerne un procédé pour limiter la croissance épitaxiale dans un dispositif photoélectrique à hétérojonctions comprenant un substrat de silicium cristallin et au moins une couche de silicium amorphe ou microcristallin, ce procédé étant caractérisé en ce qu'il comprend une étape de texturation de la surface de silicium cristallin.

## Description

### Domaine technique

La présente invention se rapporte au domaine des dispositifs photoélectriques. Elle concerne, plus particulièrement un procédé pour limiter la croissance épitaxiale dans un dispositif photoélectrique à hétérojonctions comprenant un substrat de silicium cristallin. La présente invention concerne également ledit dispositif photoélectrique.

La présente invention trouve une application particulièrement intéressante pour la réalisation de cellules photovoltaïques destinées à la production d'énergie électrique, mais elle s'applique également, de manière plus générale, à toute structure dans laquelle un rayonnement lumineux est converti en un signal électrique, telle que les photodétecteurs.

### Etat de la technique

D'une manière connue, les dispositifs photoélectriques à hétérojonctions comprennent un substrat en silicium cristallin recouvert d'une couche ou plusieurs couches de silicium amorphe ou de silicium microcristallin. Un tel dispositif peut ainsi comprendre, dans l'ordre, un substrat en silicium cristallin, une couche de silicium amorphe hydrogéné et une couche de silicium microcristallin hydrogéné.

Afin d'améliorer les performances, et en particulier le courant de sortie, des dispositifs à hétérojonctions comprenant un substrat en silicium cristallin, il est connu de modifier la texturation de la surface de silicium cristallin en formant de nombreuses sections irrégulières de forme pyramidale par un procédé de gravure anisotrope, tel que cela est décrit dans le brevet US 4,137,123. Le procédé de gravure chimique humide anisotrope en milieu alcalin utilisé pour former les pyramides a pour conséquence de produire des vallées dont le fond présente des arêtes vives. On appelle vallée la zone reliant la base des pyramides.

Dans certaines publications, notamment le brevet US 6,207,890, il a été observé que, dans ces vallées présentant des arêtes vives, le dépôt de silicium amorphe hydrogéné n'est pas suffisamment épais, ce qui a pour inconvénient de diminuer la tension de circuit ouvert (V_{co}) et le facteur de remplissage (FF) des cellules solaires à hétérojonctions à substrat de silicium cristallin. Le brevet US 6,207,890 résout ce problème en proposant de réaliser une gravure isotrope du substrat afin d'arrondir le fond des vallées, ce qui a pour effet de pouvoir déposer une couche de silicium amorphe ou microcristallin d'épaisseur uniforme par un procédé de dépôt chimique en phase vapeur assisté par plasma (PECVD).

En utilisant des conditions de dépôts (PECVD) appropriées et connues de l'Homme du métier, il est possible d'obtenir des cellules à hétérojonctions dans lesquelles la couche de silicium amorphe ou microcristallin déposée sur le substrat de silicium cristallin présente une épaisseur constante, même si ledit substrat présente une texture pyramidale suite à l'utilisation d'un procédé de gravure anisotrope. Cependant, il a été observé un processus d'épitaxie dans les vallées à arêtes vives du substrat de silicium cristallin lors de la croissance du silicium amorphe ou microcristallin hydrogéné. Cette croissance épitaxiale locale a pour inconvénient de diminuer la tension de circuit ouvert (V_{co}) des cellules solaires à hétérojonctions à substrat de silicium cristallin et donc leur rendement.

Un but de la présente invention est donc de pallier cet inconvénient, en proposant un procédé permettant de réduire la croissance épitaxiale locale et de limiter l'influence de l'épitaxie dans un dispositif photoélectrique à hétérojonctions, comprenant un substrat de silicium cristallin présentant une texture pyramidale, lors de la croissance de silicium amorphe ou microcristallin hydrogéné.

### Divulgation de l'invention

A cet effet, et conformément à la présente invention, il est proposé un procédé pour limiter la croissance épitaxiale dans un dispositif photoélectrique à hétérojonctions comprenant un substrat de silicium cristallin et au moins une couche de silicium amorphe ou microcristallin, ce procédé étant caractérisé en ce qu'il comprend une étape de texturation de la surface de silicium cristallin.

Dans une première variante de réalisation, appelée variante A, ladite étape de texturation comprend la formation de pyramides sur le substrat de silicium cristallin, lesdites pyramides présentant une base dont les dimensions sont strictement supérieures à 5 µm. De préférence, la majorité de la surface du c-Si, soit strictement plus que la moitié, est couverte par des pyramides dont les dimensions sont strictement supérieures à 5 µm. De préférence, la base desdites pyramides présente des dimensions comprises entre 5 µm et 25 µm, et plus préférentiellement entre 10 µm exclus et 20 µm. La formation de pyramides de grandes tailles permet de diminuer la densité de vallées par unité de surface.

Les pyramides peuvent être formées par gravure anisotrope, par exemple par un mélange KOH/IPA ou par une solution de NaOH, ou de TMAH (avec ou sans IPA) ou un mélange Na₂CO₃/NaHCO₃.

Dans une deuxième variante de réalisation, appelée variante B, ladite étape de texturation comprend la formation de pyramides sur le substrat de silicium cristallin, lesdites pyramides présentant un agencement régulier défini par une faible présence de pyramides submicrométriques (moins de 20 % de la surface du c-Si est couverte de pyramides ayant des dimensions submicrométriques) et plus de la moitié au moins de la surface du c-Si est couverte de pyramides dont les dimensions b de la base sont comprises dans un intervalle b ±5 µm. Préférentiellement, moins de 10 % de la surface du c-Si est couverte de pyramides ayant des dimensions submicrométriques et plus des 2/3 de la surface du c-Si est couverte de pyramides dont les dimensions b de la base sont comprises dans un intervalle b ±2.5 µm. Cette étape permet de diminuer la densité de vallées par unité de surface, d'une part, en limitant les éléments de texture submicrométrique et d'autre part en limitant les pyramides imbriquées.

Cette étape peut être réalisée par gravure anisotrope, par exemple par un mélange KOH/IPA avec une attention portée à l'uniformité de la température (par exemple selon le procédé décrit dans W. Sparber et al. « Comparison of Texturing Methods for Monocrystalline Silicon Solar Cells Using KOH and Na₂CO₃ », Proc. of the 3rd World Conf. on Photovoltaic, Osaka, 2003) ou par une solution de NaOH, ou de TMAH (avec ou sans IPA) ou un mélange Na₂CO₃/NaHCO₃. Les paramètres du procédé de gravure sont adaptés en fonction de l'état de surface initial du substrat de silicium cristallin.

Dans une troisième variante de réalisation, appelée variante C, ladite étape de texturation comprend la formation de pyramides et de vallées sur le substrat de silicium cristallin, lesdites vallées présentant un fond arrondi.

Le fond arrondi des vallées présente un rayon de courbure supérieur à 0,005 µm et de préférence compris entre 0,05 µm et 15 µm. Au moins 50 % des pyramides doivent avoir un tel fond arrondi, préférentiellement au moins 75 %.

Cette étape peut être réalisée par gravure isotrope par exemple à l'aide d'une solution dite de CP133 soit un mélange de HF (50 % in H₂O désionisé), de HNO₃ (100 % fumant) et de CH₃COOH (100%), dans les proportions 1:3:3. Une solution contenant uniquement du HF et du HNO₃ peut aussi être utilisée.

En fonction de l'état de surface initial du substrat de silicium cristallin, cette étape peut se décomposer en deux étapes, tout d'abord la formation des pyramides irrégulières sur un substrat de silicium cristallin selon par exemple le procédé décrit dans la publication W. Sparber et al. « Comparison of Texturing Methods for Monocrystalline Silicon Solar Cells Using KOH and Na₂CO₃ », Proc. of the 3rd World Conf. on Photovoltaic, Osaka, 2003 et ensuite l'arrondissement du fond des vallées par gravure isotrope.

L'homme du métier sait adapter les paramètres des différents procédés en fonction de l'effet recherché. Notamment, l'homme du métier peut se référer à la publication W. Sparber, O. Schultz, D. Biro, G. Emanuel, R. Preu, A. Poddey and D. Borchert, "Comparison of Texturing Methods for Monocrystalline Silicon Solar Cells Using KOH and Na2CO3", Proc. of the 3rd World Conf. on Photovoltaic, Osaka, 2003. De plus, l'uniformité de la température et de l'agitation sont des paramètres importants pour obtenir une texture uniforme.

Les trois variantes de réalisation A, B et C peuvent être combinées les unes aux autres, par deux ou trois.

Ainsi, il est possible de mettre en oeuvre le procédé de l'invention en appliquant séparément l'une ou l'autre des variantes A, B ou C, ou en combinant les variantes A et B, A et C, B et C, ou A, B et C. Les étapes en combinaison A et B peuvent être réalisées en une seule étape.

Après l'étape de texturation de la surface de silicium cristallin, au moins une couche de silicium amorphe ou microcristallin est déposée sur le substrat de silicium cristallin ainsi texturé pour obtenir un dispositif photoélectrique à hétérojonctions selon les techniques connues de l'homme du métier.

La présente invention concerne un dispositif photoélectrique à hétérojonctions comprenant un substrat de silicium cristallin dans lequel le processus d'épitaxie lors de la croissance de silicium amorphe ou microcristallin hydrogéné sur ledit substrat de silicium cristallin a été limité selon l'un des deux premiers procédés A et B décrit ci-dessus. Selon une première variante de réalisation, un tel dispositif peut comprendre un substrat de silicium cristallin texturé présentant à sa surface des pyramides présentant une base dont les dimensions sont strictement supérieures à 5 µm, de préférence comprises entre 5 µm et 25 µm, et plus préférentiellement entre 10 µm et 20 µm.

Selon une autre variante de réalisation, le dispositif photoélectrique de l'invention comprend un substrat de silicium cristallin texturé présentant à sa surface des pyramides présentant un agencement régulier défini par une faible présence de pyramides submicrométriques (moins de 20 % de la surface du c-Si est couverte de pyramides ayant des dimensions submicrométriques) et plus de la moitié au moins de la surface du c-Si est couverte de pyramides dont les dimensions b de la base sont comprises dans un intervalle b ±5 µm. Préférentiellement, moins de 10 % de la surface du c-Si est couverte de pyramides ayant des dimensions submicrométriques et plus des 2/3 de la surface du c-Si est couverte de pyramides dont les dimensions b de la base sont comprises dans un intervalle b ±2.5 µm.

De plus, ledit substrat de silicium cristallin ainsi texturé selon l'une ou l'autre desdites variantes peut comprendre des vallées présentant un fond arrondi. Le fond arrondi des vallées peut présenter un rayon de courbure supérieur à 0,005 µm et de préférence compris entre 0,05 µm et 15 µm. Le fond arrondi des vallées est obtenu selon le procédé C décrit ci-dessus.

Par ailleurs, les deux variantes définies ci-dessus peuvent être combinées de manière à obtenir un dispositif comprenant un substrat de silicium cristallin texturé présentant à sa surface des pyramides présentant une base dont les dimensions sont strictement supérieures à 5 µm et présentant un agencement régulier défini par une faible présence de pyramides submicrométriques (moins de 20 % de la surface du c-Si est couverte de pyramides ayant des dimensions submicrométriques) et plus de la moitié au moins de la surface du c-Si est couverte de pyramides dont les dimensions b de la base sont comprises dans un intervalle b ±5 µm. Préférentiellement, moins de 10 % de la surface du c-Si est couverte de pyramides ayant des dimensions submicrométriques et plus des 2/3 de la surface du c-Si est couverte de pyramides dont les dimensions b de la base sont comprises dans un intervalle b ±2.5 µm.

Là encore, ledit substrat de silicium cristallin ainsi texturé peut comprendre des vallées présentant un fond arrondi, tel que défini ci-dessus.

De plus, l'étape d'arrondissement du fond des vallées permet également, si l'on contrôle le temps de gravure isotrope, d'arrondir le sommet des pyramides, en contrôlant toutefois le processus pour ne pas diminuer la quantité de lumière piégée. Cela permet d'améliorer la robustesse des cellules solaires au cours de l'étape d'assemblage. En effet, arrondir le sommet des pyramides permet de réduire significativement les défauts mécaniques pendant l'assemblage des cellules en diminuant le nombre de sommets de pyramides qui pourraient être cassés, en particulier lorsque ces sommets sont particulièrement pointus.

Ainsi, et selon une variante de réalisation préférée de l'invention, on obtient un dispositif photoélectrique à hétérojonctions comprenant un substrat de silicium cristallin texturé présentant à sa surface des pyramides et des vallées, lesdites pyramides présentant une base dont les dimensions sont strictement supérieures à 5 µm et présentant un agencement régulier défini par une faible présence de pyramides submicrométriques (moins de 20 % de la surface du c-Si est couverte de pyramides ayant des dimensions submicrométriques) et plus de la moitié au moins de la surface du c-Si est couverte de pyramides dont les dimensions b de la base sont comprises dans un intervalle b ±5 µm. Préférentiellement, moins de 10 % de la surface du c-Si est couverte de pyramides ayant des dimensions submicrométriques et plus des 2/3 de la surface du c-Si est couverte de pyramides dont les dimensions b de la base sont comprise dans un intervalle b ±2.5 µm, et lesdites vallées présentant un fond arrondi, dont le rayon de courbure est supérieur à 0,005 µm et de préférence compris entre 0,05 µm et 15 µm.

Les dispositifs selon l'invention ainsi obtenus présentent des rendements supérieurs aux dispositifs à hétérojonctions existants.

### Exemples

Trois cellules photovoltaïques à hétérojonctions sont préparées en suivant les étapes A, B, A et B, et A, B et C pour la texturation du substrat de silicium cristallin.

Les étapes A et B sont réalisées conformément à la publication W. Sparber, O. Schultz, D. Biro, G. Emanuel, R. Preu, A. Poddey and D. Borchert, "Comparison of Texturing Methods for Monocrystalline Silicon Solar Cells Using KOH and Na2CO3", Proc. of the 3rd World Conf. on Photovoltaic, Osaka, 2003, pour obtenir les caractéristiques de l'invention.

Pour l'étape C, le substrat est trempé dans une solution aqueuse comprenant du fluorure d'hydrogène (HF) à 50%, de l'acide nitrique (100% fumant) et de l'acide acétique (CH₃COOH) à 100% dans un rapport 1:3:3, pendant environ 5 secondes pour une solution fraichement préparée ou environ 1 minute dans les autres cas.

A titre comparatif, on réalise une cellule photovoltaïque dont le substrat de silicium cristallin est formé de pyramides petites (dimensions de la base inférieures à 5 µm) et irrégulières préparées selon le procédé décrit dans la publication King et al. «Experimental Optimization of an Anisotropic etching process for random texturization of silicon solar cells», 22nd IEEE PSC 1991 et sans porter attention ni à la taille ni à la régularité des pyramides.

On mesure les paramètres suivants: la tension de circuit ouvert (V_{co}), le facteur de remplissage (FF), la densité de courant de court-circuit (J_{cc}) et le rendement selon la norme AM 1.5.

Les résultats sont indiqués dans le tableau ci-dessous

| Exemples | V_{co} (mV) | FF (%) | J_{cc} (mA/cm²) | Rendement (%) |
|---|---|---|---|---|
| Comparatif | 601 | 68,4 | 34,5 | 14,2 |
| Etape A | 631 | 72,9 | 34,6 | 15,5 |
| Etape B | 618 | 69,5 | 34,6 | 14,9 |
| Etapes A+B | 660 | 68,9 | 35,6 | 16,0 |
| Etapes A+B+C | 700 | 67,0 | 36,5 | 17,0 |

Les résultats de ce tableau montrent que par le procédé selon l'invention, les performances des dispositifs photoélectriques à hétérojonctions sont améliorées, en particulier lorsque les trois étapes A, B et C sont combinées.

## Revendications

1. Procédé pour limiter la croissance épitaxiale dans un dispositif photoélectrique à hétérojonctions comprenant un substrat de silicium cristallin et au moins une couche de silicium amorphe ou microcristallin, **caractérisé en ce qu'**il comprend une étape de texturation de la surface dudit substrat de silicium cristallin.

2. Procédé selon la revendication 1, **caractérisé en ce que** ladite étape de texturation est une étape A comprenant la formation de pyramides sur le substrat de silicium cristallin, lesdites pyramides présentant une base dont les dimensions sont strictement supérieures à 5 µm.

3. Procédé selon la revendication 2, **caractérisé en ce que** ladite étape de texturation A comprend la formation de pyramides sur le substrat de silicium cristallin, la majorité de la surface du substrat de silicium cristallin étant couverte par des pyramides dont les dimensions sont strictement supérieures à 5 µm.

4. Procédé selon l'une quelconque des revendications 2 et 3, **caractérisé en ce que** la base desdites pyramides présente des dimensions comprises entre 5 µm exclus et 25 µm, et plus préférentiellement entre 10 µm et 20 µm.

5. Procédé selon l'une quelconque des revendications précédentes, **caractérisé en ce que** ladite étape de texturation A de la surface dudit substrat de silicium cristallin est réalisée par gravure anisotrope.

6. Procédé selon la revendication 1, **caractérisé en ce que** ladite étape de texturation est une étape B comprenant la formation de pyramides sur le substrat de silicium cristallin, lesdites pyramides présentant un agencement régulier tel que moins de 20 % de la surface du silicium cristallin est couverte de pyramides ayant des dimensions submicrométriques et plus de la moitié au moins de la surface du silicium cristallin est couverte de pyramides dont les dimensions b de la base sont comprises dans un intervalle b ±5 µm.

7. Procédé selon la revendication 6, **caractérisé en ce que** ladite étape de texturation B comprend la formation de pyramides sur le substrat de silicium cristallin, lesdites pyramides présentant un agencement régulier tel que moins de 10 % de la surface du silicium cristallin est couverte de pyramides ayant des dimensions submicrométriques et plus des 2/3 de la surface du silicium cristallin est couverte de pyramides dont les dimensions b de la base sont comprises dans un intervalle b ±2.5 µm.

8. Procédé selon l'une quelconque des revendications 6 et 7, **caractérisé en ce que** ladite étape de texturation B de la surface dudit substrat de silicium cristallin est réalisée par gravure anisotrope.

9. Procédé selon la revendication 1, **caractérisé en ce que** ladite étape de texturation est une étape C comprenant la formation de pyramides et de vallées sur le substrat de silicium cristallin, lesdites vallées présentant un fond arrondi.

10. Procédé selon la revendication 9, **caractérisé en ce que** le fond arrondi des vallées présente un rayon de courbure supérieur à 0,005 µm, de préférence compris entre 0,05 µm et 15 µm.

11. Procédé selon l'une quelconque des revendications 9 et 10, **caractérisé en ce que** au moins 50 % desdites pyramides, préférentiellement au moins 75 % desdites pyramides, sont reliées par une vallée dont le fond arrondi présente un rayon de courbure supérieur à 0,005 µm, de préférence compris entre 0,05 µm et 15 µm.

12. Procédé selon l'une quelconque des revendications 9 à 11, **caractérisé en ce que** ladite étape de texturation C de la surface dudit substrat de silicium cristallin est réalisée par gravure isotrope.

13. Procédé selon l'une quelconque des revendications 9 à 11, **caractérisé en ce que** ladite étape de texturation C de la surface dudit substrat de silicium cristallin se décompose en deux étapes, à savoir tout d'abord la formation des pyramides irrégulières sur un substrat de silicium cristallin réalisée par gravure anisotrope, et ensuite l'arrondissement du fond des vallées par gravure isotrope.

14. Procédé selon l'une quelconque des revendications précédentes, **caractérisé en ce que** ladite étape de texturation de la surface du substrat de silicium cristallin consiste en une combinaison, par deux ou trois, des étapes de texturation A, B et C.

15. Procédé selon la revendication 14, **caractérisé en ce qu'**il comprend:
- une étape de texturation de la surface du substrat de silicium cristallin réalisée par gravure anisotrope pour former à la surface dudit substrat de silicium cristallin des pyramides présentant une base dont les dimensions sont strictement supérieures à 5 µm, et présentant un agencement régulier tel que moins de 20 % de la surface du silicium cristallin est couverte de pyramides ayant des dimensions submicrométriques et plus de la moitié au moins de la surface du silicium cristallin est couverte de pyramides dont les dimensions b de la base sont comprises dans un intervalle b ±5 µm, et
- une étape de texturation de la surface du substrat de silicium cristallin réalisée par gravure isotrope pour obtenir, entre lesdites pyramides, des vallées présentant un fond arrondi.

16. Dispositif photoélectrique à hétérojonctions comprenant un substrat de silicium cristallin présentant une surface texturée et au moins une couche de silicium amorphe ou microcristallin, dans lequel a été limitée l'épitaxie lors de la croissance dudit silicium amorphe ou microcristallin sur ledit substrat de silicium cristallin, la limitation de l'épitaxie ayant été obtenue par le procédé selon l'une quelconque des revendications 1 à 15.

17. Dispositif photoélectrique à hétérojonctions comprenant un substrat de silicium cristallin présentant une surface texturée et au moins une couche de silicium amorphe ou microcristallin, dans lequel a été limitée l'épitaxie lors de la croissance dudit silicium amorphe ou microcristallin sur ledit substrat de silicium cristallin, **caractérisé en ce que** ledit substrat de silicium cristallin texturé présente à sa surface des pyramides présentant une base dont les dimensions sont strictement supérieures à 5 µm, de préférence comprises entre 5 µm exclus et 25 µm, et plus préférentiellement entre 10 µm et 20 µm.

18. Dispositif selon la revendication 16, **caractérisé en ce que** lesdites pyramides présentent en outre un agencement régulier tel que moins de 20 % de la surface du silicium cristallin est couverte de pyramides ayant des dimensions submicrométriques et plus de la moitié au moins de la surface du silicium cristallin est couverte de pyramides dont les dimensions b de la base sont comprises dans un intervalle b ±5 µm.

19. Dispositif photoélectrique à hétérojonctions comprenant un substrat de silicium cristallin présentant une surface texturée et au moins une couche de silicium amorphe ou microcristallin, dans lequel a été limitée l'épitaxie lors de la croissance dudit silicium amorphe ou microcristallin sur ledit substrat de silicium cristallin, **caractérisé en ce que** ledit substrat de silicium cristallin texturé présente à sa surface des pyramides présentant un agencement régulier tel que moins de 20 % de la surface du silicium cristallin est couverte de pyramides ayant des dimensions submicrométriques et plus de la moitié au moins de la surface du silicium cristallin est couverte de pyramides dont les dimensions b de la base sont comprises dans un intervalle b ±5 µm.

20. Dispositif selon l'une quelconque des revendications 17 et 18, **caractérisé en ce que** moins de 10 % de la surface du silicium cristallin est couverte de pyramides ayant des dimensions submicrométriques et plus des 2/3 de la surface du silicium cristallin est couverte de pyramides dont les dimensions b de la base sont comprises dans un intervalle b ±2.5 µm.

21. Dispositif selon l'une quelconque des revendications 16 à 19, **caractérisé en ce que** ledit substrat de silicium cristallin présente entre les pyramides, des vallées présentant un fond arrondi.

22. Dispositif selon la revendication 20, **caractérisé en ce que** ledit fond arrondi des vallées présente un rayon de courbure supérieur à 0,005 µm, de préférence compris entre 0,05 µm et 15 µm.
